# EUROPEAN PATENT APPLICATION

(11) **EP 1 835 295 A1**
(43) Date of publication of application: **19.09.2007**
(21) Application number: 06111348.6
(22) Date of filing: 17.03.2006
(51) Int. Cl.: G01R 31/02

(54) **Test connector, kit and method for distinguishing a group of wires from other wires of a multi-wire cable**

(71) Applicant: 3M Innovative Properties Company, St. Paul, MN 55133-3427 (US)
(72) Inventor: Van Meijl, H.F.M., 5712 NK Someren-Eind (NL); Goertz, Joachim, 52078 Aachen (DE); Teunissen, Johan, 6071 SE Swalmen (NL)
(74) Representative: Hilleringmann, Jochen

(57) **Abstract**

The method for distinguishing a first group of wires from other wires of a multi-wire cable connected to a first connector (20) comprises a step of
providing a mating test connector (38) wherein the contact elements (42) of the first group of the test connector (38) are short-circuited, and a step of
distinguishing the wires (14) of the first group in that indicator (62) indicates flow of a current, no voltage and/or no resistance.

## Description

### BACKGROUND OF THE INVENTION

### Field of the Invention

The present invention relates to a method for distinguishing a first group of wires from other wires of a multi-wire cable, i.e. a method for identifying those wires of a multi-wire cable which belong to one group. Moreover, the present invention relates to a test connector for use in the method referred to before. Finally the present invention relates to a kit including a multi-wire cable with a connector and a mating test connector for performing the identification method.

### Related Prior Art

In the field of telecommunication wiring it is known to use cable harnesses including a connector and a multi-wire cable having an outer jacket surrounding a plurality of individual wires. The cable and its wires are connected to contact elements of the connector. The connector comprises a connector shell accommodating the individual contact elements. In twisted-pair and parallel-pair wire cables, each pair comprises an A wire and a B wire. One difficulty in using these cable harnesses is to identify the A and the B wires at the end of the cable opposite the connector. Namely, in order to correctly connect the wires of the cable harness to a circuitry or other electronic telecommunication equipment, it is important to be able to distinguish between these two groups of wires also under disadvantageous environmental conditions like reduced space and decreased recognizability of the color of the insulations of the wires.

In the prior art it is known to test telecommunication multi-pair or multi-wire cables. Examples for corresponding test equipments are described in US-A-4 277 740, US-A-4 937 519, US-A-5 847 557, US-A-6 002 247, JP-A-08-029474, JP-A-2000-310659, and DE-C-196 23 912. While the known test equipments comprise rather complicated electric and electronic circuitries, the known devices in the first place are used in order to check whether individual wires function correctly. With the known test equipments it is not possible to identify or distinguish e.g. the A wires of a telecommunication multi-wire cable from the other wires of the cable.

Accordingly, there is a need for a method for distinguishing a first group of wires from other wires of a multi-wire cable which method can be easily performed with reduced expenditure in hardware efforts.

### SUMMARY OF THE INVENTION

The invention provides a method for distinguishing a first group of wires from other wires of a multi-wire cable,
- wherein the cable is connected to a first connector having a plurality of contact elements connected to the wires of the cable and adapted to be connected to a mating second connector and
- wherein the contact elements comprise a first group of contact elements connected to the first group of wires of the cable,
   wherein the method comprises the following steps:

- providing a mating test connector having contact elements to be connected to the contact elements of the first connector, wherein the contact elements of the test connector comprise a first group of contact elements to be connected to the first group of contact elements of the first connector, and wherein the contact elements of the first group of the test connector are short-circuited,
- providing a testing device comprising first and second terminals and a power supply as well as at least one of a current, voltage or resistance indicator connected between the two terminals,
- electrically coupling the first terminal of the testing device to the short-circuited contact elements of the first group of the test connector and
- sequentially electrically coupling the second terminal of the testing device to the wires of the cable at their respective ends opposite the first connector for distinguishing the wires of the first group from other wires of the cable in that a wire which at its end opposite the first connector is electrically coupled to the second terminal of the testing device, belongs to the first group of wires if the indicator indicates flow of a current, no or substantially no voltage and/or no or substantially no resistance, respectively.

In one preferred embodiment of the present invention, all the contact elements of the (first) connector of a cable harness to which contact elements the wires of a first group of wires are connected, are short-circuited using a test connector mating with the first connector of the cable harness. A simple beeper, i.e. a simple multimeter/circuit analyzer can now be used in order to identify at the end of the cable opposite its first connector whether or not the individual wires belong to the first group. This is performed in that the testing device, i.e. a multimeter or circuit analyzer is connected between the short-circuited contact elements of the first connector and each of the wires at the end of the cable opposite the first connector. The testing device comprises a power supply as well as at least one indicator indicating flow of a current, a voltage, or a resistance.

In a preferred embodiment, short-circuiting of the elements of the first group of contact elements of the first connector is performed by using a mating test connector having contact elements to be connected to the contact elements of the first connector, wherein the contact elements of the test connector comprises a first group of contact elements to be connected to the first group of contact elements of the first connector and wherein the contact elements of the first group of the test connector are short-circuited.

Accordingly, the present invention provides easy and simply constructed test equipment, namely the mating test connector and a multimeter or circuit analyzer (testing device as referred to above) which belongs to the standard equipment of everyone dealing with the installation and connection of multi-wire cables.

When performing the above-mentioned method, one of the two terminals of the testing device has to be connected to the mating test connector, i.e. adjacent the end of the cable provided with the first connector, while the other terminal of the testing device has to be selectively and sequentially connected to the wires at the other end of the cable. This might raise difficulties if the first connector and the opposite end of the cable, i.e. the free ends of the wires are located remote from each other. Normally, multi-wire cables having twisted-pair or parallel-pair wires comprise a shielding arranged internally of the jacket of the cable and surrounding the wires thereof. Therefore, in a preferred embodiment of the invention the shielding can be used in order to electrically couple the short-circuited first group of contact elements of the test connector at the site of the first connector to the shielding so that the one terminal end of the testing device now can be electrically coupled to the shielding of the cable at its end opposite the first connector, i.e. at the end of the cable where also access to the ends of the wires is possible. Accordingly, the testing device can be connected with its terminals at one end of the cable, i.e, at the end of the cable where the wires terminate with their free ends.

In order to improve the electrical coupling to the shielding of the cable, a so-called drain wire can be used which normally is present in a cable having twisted-pair or parallel-pair wires. The (first) end of the drain wire located in the first connector can be electrically coupled to the first group of short-circuited contact elements of the test connector while the second end of the drain wire located at the end of the cable opposite the first connector can be used for electrically coupling to the testing device.

However, also in the applications where the wires of cables of harnesses have to be identified without the cable being provided with a shielding or drain wire, it is possible to electrically couple the first terminal of the testing device to the short-circuited contact elements of the test connector at the end of the cable opposite the first connector and, accordingly, the test connector. Therefore, in one embodiment of the invention, the step of electrically coupling the first terminal of the testing device to the short-circuited contact elements of the first group of the test connector comprises electrically coupling the first terminal of the testing device to at least one of the wires of the first group identified before by electrically coupling the two terminals of the testing device to different pairs of two wires until the indicator indicates flow of a current, no or substantially no voltage, and/or no or substantially no resistance, respectively, and selecting one of the two wires of the respective pair belonging to the first group of wires for electrically coupling to the first terminal of the testing device.

It might be necessary that several pairs of wires of the cable have to be selected sequentially for electrically coupling them to the testing device until one will have found a pair of wires for which the indicator indicates flow of current, or no or substantially no voltage or resistance, respectively. Thus, these two wires belong to the first group of wires so that one of these two wires thereafter can be used for electrically coupling to the first terminal of the testing device in order to identify the remaining wires of the first group of wires.

Normally, the shielding or the drain wire of the cable comprising twisted-pair or parallel-pair wires is connected to the shell of the first connector if the shell comprises electrically conductive material. If the shell is made from an electrically non-conductive material, the drain wire or shielding is electrically connected to some elements of the shelf made from electrically conductive material. Such an element for example can be a mechanical fastener such as a screw or the like by which the first connector can be fastened and fixed to a face plate or the like component of a housing or unit having a connector mating with the first connector and to which the first connector has to be connected for normal use of the cable. Accordingly, in one embodiment of the present invention the first connector comprises at least one mechanical fastener electrically conductive and adapted to be fastened to an electrically conductive mating fastening element of the test connector of a component comprising the test connector, wherein the first group of short-circuited contact elements of the test connector is electrically coupled to the fastening element.

As mentioned earlier, the testing device can be a standard multimeter/circuit analyzer or beeper indicating optically or acoustically whether or not two contact points to which the probes or terminals of the testing device are connected, are short-circuited.

The above-mentioned method can be used for identifying different groups of wires of a multi-wire cable. Accordingly, in order to identify the wires of a first group of wires, the method as referred to above is performed. In order to identify the wires of a second group of wires of the multi-wire cable, according to one alternative of the invention an alternative further mating test connector can be used for short-circuiting the second group of contact elements of the first connector which contact elements are connected to the wires of the second group. The process comprises the following steps:
- providing a further mating test connector having contact elements to be connected to the contact elements of the first connector, wherein the contact elements of the further test connector comprise a second group of contact elements to be connected to the second group of contact elements of the first connector and wherein the contact elements of the second group of the further test connector are short-circuited,
- electrically coupling the first terminal of the testing device to the short-circuited contact elements of the second group of the further test connector, and
- sequentially electrically coupling the second terminal of the testing device to the wires of the cable not distinguished so far at their ends opposite the first connector, for distinguishing the wires of the second group from other wires of the cable in that a wire which at its end opposite the first connector is electrically coupled to the second terminal of the testing device belongs to the second group of wires if the indicator indicates flow of a current, no or substantially no voltage and/or no or substantially no resistance, respectively.

As an alternative to the above-mentioned method, several groups of wires to be distinguished from each other as well as other wires of the cable can also be distinguished by using one mating test connector only, which test connector comprises two groups of contact elements to be connected to the contact elements of the two groups of the first connector, respectively, wherein the contact elements of the first group of the test connector are short-circuited among each other while the contact elements of the second group of the test connector are also short-circuited among each other. For example, in order to identify a first group of wires of a cable having three different groups of wires to be distinguished from each other, the testing equipment has to be connected to the first group of contact elements of the test connector and, after having identified all the wires of the first group, the testing equipment is connected to the second group of short-circuited contact elements of the test connector and so on, Switching from the first group of short-circuited contact elements to a second group or further group of short-circuited contact elements can be facilitated by means of a switch e.g. arranged at the test connector for routing the short-circuited contact elements of the respective groups to the first terminal of the testing device. By this arrangement each group of short-circuited contact elements of the test connector can be connected to a terminal of the test connector which the first terminal of the testing device is electrically coupled to, i.e. in that the shielding or drain wire of the cable if provided is connected to that terminal of the connector.

Accordingly, as mentioned before, a test connector which can be used for performing the method referred to before, comprises a plurality of contact elements to be connected to the contact elements of the first connector wherein the contact elements of the test connector comprise a first group of contact elements to be connected to the first group of contact elements of the first connector and wherein the contact elements of the first group of the test connector are short-circuited.

In another preferred embodiment of the present invention, the test connector merely comprises contact elements for the contact elements of the first connector to which the group of wires to be identified are connected. This means that the test connector in a preferred embodiment has less contact elements than the connector of the cable harness. Such a design is advantageous in that the forces necessary to engage the connector of the cable harness and the test connector as well as to disengage these connectors are reduced which facilitates handling of the test connector.

In another preferred embodiment of the present invention, the test connector comprises a printed circuit board having a common conductive trace connected to the first group of contact elements of the test connector. The connection of the first group of contact elements to the common conductive trace of the printed circuit board can be performed by soldering or press fitting the contact elements into bores of the printed circuit board. However, also other methods of short-circuiting the first group of contact elements of the test connector are possible, i.e. by soldering a blank wire or other conductor element to these contact elements or by using a plate or the like element comprising a conductive layer to which the contact elements are connected e.g. by press fits.

If the test connector shall be used for identifying several groups of wires, the test connector in a preferred embodiment of the invention comprises a printed circuit board having two conductive traces, the one being connected to the first group of contact elements and the other being connected to a further group of contact elements of the test connector. More than two conductive traces isolated from each other can be provided on the printed circuit board of the test connector in order to identify the wires of more than two groups of wires of the cable.

In order to further improve handling of the test connector, the test connector comprises a handle opposite the ends of the contact elements facing the contact elements of the first connector of the cable when to be connected therewith.

In a further embodiment of the present invention, the test connector comprises a header having a carrier body made of electrically non-conductive material and supporting a plurality of contact pins to be connected to socket contact elements of the connector of the cable harness. A pin header can be easily attached to a printed circuit board. A common trace of the printed circuit board serves for short-circuiting the contact pins or a group of contact pins of the pin header while a handle can be easily attached to the assembly of the pin header and printed circuit board at the side of the printed circuit board opposite the pin header.

### BRIEF DESCRIPTION OF THE DRAWINGS

The invention will be described in more detail referring to an embodiment thereof depicted in the drawings in which
- Fig. 1: schematically shows the basic arrangement of the test socket, the cable harness and the electrical and mechanical connection therebetween as well as the electrical connection to the testing device,
- Fig. 2: is a view taken along line II-II of Fig. 1 and showing the array of the contact elements of the connector of the cable harness, and
- Fig. 3: is a view taken along III-III of Fig. 1 showing a common trace on the printed circuit board of the test connector for short-circuiting individual contact elements of the test connector.

### DESCRIPTION OF A PREFERRED EMBODIMENT

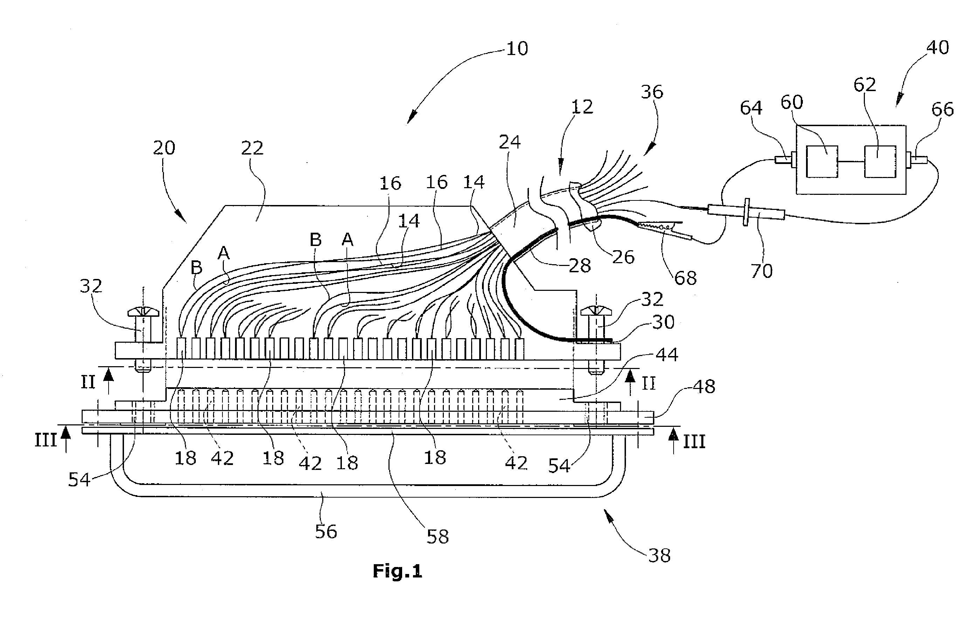

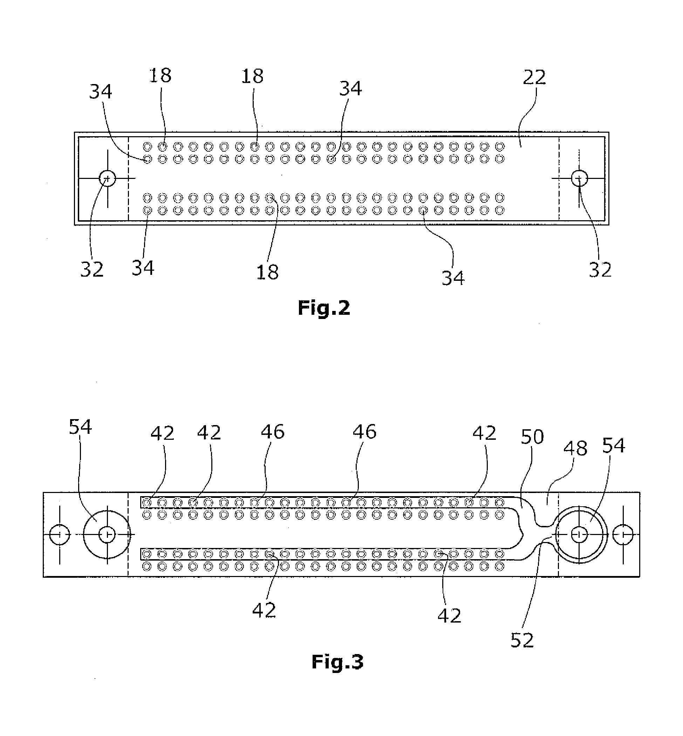

Fig. 1 shows the individual elements for identifying a first group of wires of a multi-wire cable for telecommunication purposes. In Fig. 1 there is depicted a cable harness 10 comprising a multi-wire cable 12 having twisted-pair or parallel-pair cables 14,16 connected to contact elements 18 of a (first) connector 20 comprising a shell or hood 22. The cable 12 includes an outer jacket 24 and a shielding 26 arranged within the outer jacket 24 wherein the shielding 26 and the outer jacket 24 surround the plurality of wires 14,16. Moreover, a drain wire 28 extends within the shielding 26 of the cable 12 and contacts the shielding 26. The drain wire 28 is used for electrically connecting the shielding 26 to a common potential of the first connector 20. In this embodiment this connection is performed by electrically connecting the drain wire 28 to an annular element 30 penetrated by a fastening element 32 formed as a screw for attaching and fixing the first connector 20 to a component (not shown) comprising a mating second connector (also not shown). As mentioned before, the invention also functions with a bundle of wires without an outer jacket and/or without a shielding around all of the wires.
As can be seen from Fig. 1, the wires 14 (also referred to as A wires) are connected to the contact elements 18 which in this embodiment are arranged in at least one row and, in particular, are arranged in two rows as shown in Fig. 2. The wires 16 (also referred to as B wires) are connected to contact elements 34 which are shown in Fig. 2 and which also are arranged in two rows. However, the arrangement of the contact elements of both the connector 20 of the cable harness 10 and the test connector (referred to later) need not to be in rows but can also be along circles and also irregular in a certain sense.

After stripping the outer jacket 24 and the shielding 26 of the cable 12 at its end 36 opposite the first connector 20, a bundle of wires 14,16 is obtained, with the resulting difficulty that depending on the ambient light, one cannot determine from the color of the outer insulations (not shown) of the individual wires 14,16 which wire belongs to which group (A wire or B wire). The test connector 38 shown in Figs. 1 and 3 serves for identifying the wires by the aid of a testing device 40 which will be explained hereinbelow.

The idea behind the identification method according to the present invention is to short-circuit the wires of a group (e:g. A wires or B wires) at their ends connected to the contact elements 18,34, respectively. In the instant example an embodiment will be described in which all the wires 14 (A wires) are short-circuited at their contact elements 18. This is performed by means of the test connector 38 which in this embodiment comprises contact elements 42 to be connected to the contact elements 18 of the connector 20 for the A wires. The test connector 38 in a preferred embodiment does not comprise more contact elements 42 than necessary for contacting all the contact elements 18 of the first connector 20 for the A wires. However, it is also possible that the test connector 38 comprises also contact elements to be connected to the contact elements 34 for the B wires of the cable harness 10, although this is not necessary for performing the invention.

The contact elements 42 carried by a carrier body 44 and, at their ends, facing away from the contact elements 18 of the first connector 20, are inserted (e.g., by a press fit or the like) into bores 46 of a circuit board 48 arranged behind the carrier body 44 opposite the first connector 20. The printed circuit board 48 comprises a common conductive trace 50 electrically connecting the contact elements 42, i.e. short-circuiting these contact elements 42 of the test connector 38. This is shown in Fig. 3. Also the common trace 50 is electrically connected to a fastening element 54 provided at the test connector 38 (see in Fig. 3 at position 52) for receiving and interacting with the fastener 32 (screw) of the connector 20 of the cable harness 10. Finally, a handle 56 and a plate 58 attached to the handle 56 are arranged at the side of the printed circuit board 48 opposite the carrier body 44. The carrier body 44 may be surrounded by a housing carrying the handle 56.

For distinguishing the A wires from the B wires of the cable 12, a standard multimeter/circuit analyzer or beeper can be used as the testing device 40 which, accordingly, includes a power source 60 and an indicator 62 connected in series and defining first and second terminals 64,66 of the testing device 40. Connected to these terminals 64,66 are two probes 68,70 the one being fixedly connected to the drain wire 28 at the end 36 of the cable 12 while the other 70 can be selectively electrically connected to the individual wires 14,16 at the end 36 of the cable 12 as shown in Fig. 1.

For identifying the A wires (wires 14), the test connector 38 is engaged with the connector 20 of the cable 12 with the fasteners 32 being fixed at the fastening elements 54 of the test connector 38. Accordingly, the short-circuited contact elements 42 of the test connector 38 are electrically coupled to the drain wire 28 so that the voltage potential of the short-circuited contact elements 42, i.e. the potential of all the A wires 14 are accessible at the drain wire 28 at the end 36 of the cable 12. The individual wires 14,16 at the end 36 of the cable 12 are now sequentially and individually contacted with the probe 70. If the indicator 62 indicates the flow of a current, or no or substantially no voltage or a resistance of zero or substantially zero Ω, this means that the drain wire 28 and the wire contacting the probe 70 have the same potential so that this wire must be an A wire. Depending on the length of the cable 12 between its connector 20 and its end 36 opposite the connector 20, it could happen that the indicator 62, if provided as a voltage or resistance indicator, does not indicate exactly a voltage of zero V or a resistance of zero Ω due to the wire resistance based on the fact that the wires have a certain resistance per length unit. However, such a small voltage drop or resistance has to be regarded as a short-circuit between the wire just connected to the testing device 40 and the short-circuited contact elements 42 of the test connector 38.

Although the invention has been described and illustrated with reference to a specific illustrative embodiment thereof, it is not intended that the invention be limited to this embodiment. Those skilled in the art will recognize that variations and modifications can be made without departing from the true scope of the invention as defined by the claims that follow. It is therefore intended to include within the invention all such variations and modifications as fall within the scope of the appended claims and equivalents thereof.

## Claims

1. A method for distinguishing a first group of wires from other wires of a Multi-wire cable,
- wherein the cable (12) is connected to a first connector (20) having a plurality of contact elements (18,34) connected to the wires (14,16) of the cable (12) and adapted to be connected to a mating second connector and
- wherein the contact elements (18,34) comprise a first group of contact elements (18) connected to the first group of wires (14) of the cable (12),
wherein the method comprises the following steps:
- providing a mating test connector (38) having contact elements (42) to be connected to contact elements (18,34) of the first connector (20), wherein the contact elements (42) of the test connector (38) comprises a first group of contact elements (42) to be connected to the first group of contact elements (18) of the first connector (20), and wherein the contact elements (42) of the first group of the test connector (38) are short-circuited,
- providing a testing device (40) comprising first and second terminals (64,66) and a power supply (60) as well as at least one of a current, voltage or resistance indicator (62) connected between the two terminals (64,66),
- electrically coupling the first terminal (64) of the testing device (40) to the short-circuited contact elements (48) of the first group of the test connector (38) and
- sequentially electrically coupling the second terminal (66) of the testing device (40) to the wires (14,16) of the cable (12) at their respective ends (36) opposite the first connector (20), for distinguishing the wires (14) of the first group from other wires (16) of the cable (12) in that a wire (14,16) which at its end (36) opposite the first connector (20) is electrically coupled to the second terminal (66) of the testing device (40), belongs to the first group of wires (14) if the indicator (62) indicates flow of a current, no or substantially no voltage and/or no or substantially no resistance, respectively.

2. The method according to claim 1, wherein the cable (12) comprises a shielding (26) surrounding the wires (14,16) and wherein the short-circuited contact elements (42) of the test connector (38) are electrically coupled to the shielding (26) of the cable (12) and the first terminal (64) of the testing device (40) in turn is electrically connected to the shielding (26) of the cable (12) at the end (36) of the cable opposite the first connector (20).

3. The method according to claim 2, wherein the cable (12) comprises a drain wire (28) extending through the cable (12) and in contact with the shielding (26) thereof and wherein the end of the drain wire (28) located at the first connector (20) is electrically coupled to the first group of short-circuited contact elements (42) of the test connector (38).

4. The method according to claim 3, wherein the first terminal (64) of the testing device (40) is electrically connected to the drain wire (28) of the cable (12) at its end opposite the first connector (20).

5. The method according to any one of claims 2 to 4, wherein the first connector (20) comprises at least one mechanical fastener (32) electrically conductive and adapted to be fastened to an electrically conductive mating fastening element (54) of the test connector (38) or a component comprising the test connector (38), and wherein the first group of short-circuited contact elements (42) of the test connector (38) are electrically coupled to the fastening element (54).

6. The method according to claim 5, wherein the shielding (26) and/or the drain wire (28) is/are electrically coupled to the at least one fastener (32) of the first connector (20).

7. The method according to any one of claims 1 to 6, wherein the cable (12) comprises several subgroups of wires (14,16), each subgroup including at least two wires (14,16), and wherein the first group of wires (14) comprises one wire (14) of each subgroup.

8. The method according to claim 1, wherein the step of electrically coupling the first terminal (64) of the testing device (40) to the short-circuited contact elements (48) of the first group of the test connector (68) comprises electrically coupling the first terminal (64) of the testing device (40) to at least one of the wires (14) of the first group identified before by electrically coupling the two terminals (64,66) of the testing device (40) to different pairs of two wires (14,16) until the indicator (62) indicates flow of a current, no or substantially no voltage, and/or no or substantially no resistance, respectively, and selecting one of the two wires (14) of the respective pair belonging to the first group of wires (14) for electrically coupling to the first terminal (64) of the testing device (40).

9. The method according to any one of claims 1 to 8, wherein the indicator (62) of the testing device (40) acoustically and/or optically indicated flow of the current, no or substantially no voltage and/or no or substantially no resistance, respectively.

10. The method according to any one of claims 1 to 9, wherein the cable comprises a second group of wires to be distinguished from the first group of wires and other wires of the cable and connected to a second group of contact elements of the first connector, wherein after the first group of wires of the cable has been distinguished from the other wires of the cable, the following steps are performed:
- providing a further mating test connector having contact elements to be connected to the contact elements of the first connector, wherein the contact elements of the further test connector comprise a second group of contact elements to be connected to the second group of contact elements of the first connector and wherein the contact elements of the second group of the further test connector are short-circuited,
- electrically coupling the first terminal of the testing device to the short-circuited contact elements of the second group of the further test connector, and
- sequentially electrically coupling the second terminal of the testing device to the wires of the cable not distinguished so far at their ends opposite the first connector, for distinguishing the wires of the second group from other wires of the cable in that a wire which at its end opposite the first connector is electrically coupled to the second terminal of the testing device belongs to the second group of wires if the indicator indicates flow of a current, no or substantially no voltage and/or no or substantially no resistance, respectively.

11. The method according to any one of claims 1 to 9, wherein the cable comprises a second group of wires to be distinguished from the first group of wires and other wires of the cable and connected to a second group of contact elements of the first connector, wherein the test connector comprises a second group of short-circuited contact elements to be connected to the second group of contact elements of the first connector, and wherein after the first group of wires has been distinguished from the other wires of the cable the following steps are performed:
- electrically coupling the first terminal of the testing device to the short-circuited contact elements of the second group of the test connector, and
- sequentially electrically coupling the second terminal of the testing device to the wires of the cable not distinguished so far at their ends opposite the first connector, for distinguishing the wires of the second group from other wires of the cable in that a wire which at its end opposite the first connector is electrically coupled to the second terminal of the testing device belongs to the second group of wires if the indicator indicates flow of a current, no or substantially no voltage and/or no or substantially no resistance, respectively.

12. The method according to any one of claims 1 to 11, wherein the wires (14,16) of the cable (12) comprise twisted-pair wires or parallel-pair wires.

13. A test connector for performing the method according to any one of the preceding claims, comprising
- a plurality of contact elements (42) to be connected to contact elements (18,34) of the first connector (20) wherein the contact elements (42) of the test connector (38) comprise a first group of contact elements (42) to be connected to the first group of contact elements (18) of the first connector (20) and wherein the contact elements (42) of the first group of the test connector (38) are short-circuited.

14. The test connector according to claim 13, wherein the cable (12) comprises a shielding (26) surrounding the wires (14,16) and wherein the short-circuited contact elements (42) of the test connector (38) are electrically coupleable to the shielding (26) of the cable (12).

15. The test connector according to claim 14, wherein the cable (12) comprises a drain wire (28) extending through the cable (12) and in contact with the shielding (26) thereof and wherein the end of the drain wire (28) located at the first connector (20) is electrically coupleable to the first group of short-circuited contact elements (42) of the test connector (38).

16. The test connector according to claim 15, wherein the first terminal (64) of the testing device(40) is electrically connected to the drain wire (28) of the cable (12) at its end (36) opposite the first connector (20).

17. The test connector according to any one of claims 13 to 16, wherein the test connector (38) merely comprises the first group of contact elements (48).

18. The test connector according to any one of claims 13 to 17, wherein a printed circuit board (48) is provided having a common conductive trace (50) connected to the first group of contact elements (48) of the test connector (38).

19. The test connector according to any one of claims 13 to 18 for performing the method of claim 8, wherein the test connector comprises a second group of short-circuited contact elements to be connected to the second group of contact elements of the first connector.

20. The test connector according to claim 19, wherein a switch is provided for selectively electrically coupling the first or second group of short-circuited contact elements of the test connector to an output terminal thereof which can be electrically coupled to the first terminal of the testing device.

21. The test connector according to claim 18 and 20, wherein the printed circuit board is provided with two conductive traces electrically isolated from each other wherein the first group of contact elements of the test connector are connected to the one conductive trace and the second group of contact elements of the test connector are connected to the other conductive trace of the printed circuit board.

22. The test connector according to any one of claims 13 to 21, wherein the test connector (38) comprises at least one mechanical fastening element (54) electrically conductive and to be fastened to an electrically conductive mating fastener (32) of the first connector (20) of the cable (12), and wherein the first group of short-circuited contact elements (48) of the test connector (38) are electrically coupled to the fastening element (54).

23. The test connector according to any one of claims 13 to 22, further comprising a handle (56) opposite the ends of the contact elements (48) of the test connector (38) facing the contact elements (18,34) of the first connector (20) of the cable (12) when to be connected therewith.

24. Kit comprising
- a multi-wire cable (12) including at least one group of wires (14) and further wires (16), wherein the cable is connected to a first connector (20) having a plurality of contact elements (18,34) connected to the wires (14,16) of the cable (12) and adapted to be connected to a mating second connector and wherein the contact elements (18,34) comprise a first group of contact elements (18) connected to the first group of wires (14) of the cable (12), and
- a mating test connector (38) including a plurality of contact elements (42) to be connected to contact elements (18,34) of the first connector (20) wherein the contact elements (42) of the test connector (38) comprise a first group of contact elements (42) to be connected to the first group of contact elements (18) of the first connector (20) and wherein the contact elements (42) of the first group of the test connector (38) are short-circuited.
